# EUROPEAN PATENT SPECIFICATION

(11) **EP 3 023 248 B1**
(45) Date of publication and mention of the grant of the patent: **16.01.2019**
(21) Application number: 15194467.5
(22) Date of filing: 13.11.2015
(51) Int. Cl.: B32B 27/00, C23C 14/06, C23C 16/26, C23C 4/04, C23C 4/18

(54) **CARBON-BASED BARRIER COATINGS FOR HIGH-TEMPERATURE POLYMER-MATRIX COMPOSITES**
KOHLENSTOFFBASIERTE SPERRBESCHICHTUNG FÜR HOCHTEMPERATUR POLYMERMATRIXVERBUNDSTOFFE
REVÊTEMENT BARRIERE À BASE DE CARBON POUR COMPOSITES HAUTE TEMPÉRATURE À MATRICE POLYMÈRE

(30) Priority: 18.11.2014 US 201414543948
(43) Date of publication of application: 25.05.2016
(73) Proprietor: The Boeing Company, Chicago, IL 60606-1596 (US)
(72) Inventor: TSOTSIS, Thomas Karl, Chicago, IL Illinois 60606-2016 (US)
(74) Representative: Boult Wade Tennant LLP

(56) References cited:
- US-A1- 2013 149 934
- US-B1- 8 778 498
- Y. SU ET AL: "Impermeable barrier films and protective coatings based on reduced graphene oxide", NATURE COMMUNICATIONS, vol. 5, 11 September 2014 (2014-09-11), page 4843, XP055194553, DOI: 10.1038/ncomms5843
- PINGAN SONG ET AL: "Fabrication of exfoliated graphene-based polypropylene nanocomposites with enhanced mechanical and thermal properties", POLYMER, ELSEVIER SCIENCE PUBLISHERS B.V, GB, vol. 52, no. 18, 24 June 2011 (2011-06-24) , pages 4001-4010, XP028263353, ISSN: 0032-3861, DOI: 10.1016/J.POLYMER.2011.06.045 [retrieved on 2011-07-13]
- NINGNING HONG ET AL: "Fabrication of graphene/Ni-Ce mixed oxide with excellent performance for reducing fire hazard of polypropylene", RSC ADVANCES, vol. 3, no. 37, 10 July 2013 (2013-07-10), page 16440, XP055461282, DOI: 10.1039/c3ra42095g
- FUJIKAWA SHIGENORI ET AL: "Preferential CO2Separation Over Nitrogen by a Free-standing and Nanometer-thick Membrane", ENERGY PROCEDIA, ELSEVIER, NL, vol. 114, 18 August 2017 (2017-08-18), pages 608-612, XP085178414, ISSN: 1876-6102, DOI: 10.1016/J.EGYPRO.2017.03.1907
- JOEL FISCHER: "Permeation and Measurement Techniques", 2007 PLACE CONFERENCE, 20 September 2007 (2007-09-20), pages 1-49, XP055461349,

## Description

### TECHNICAL FIELD

This disclosure generally relates to coatings for composites and, more particularly, to carbon-based barrier coatings for high-temperature polymer-matrix composites ("HTPMC") and methods for improving protection of HTPMC from thermo-oxidative degradation.

### BACKGROUND

Polymer-matrix composites ("PMC"), such as HTPMC, are typically used in the aircraft and aerospace industry for the weight reductions they offer when used to replace metal components. However, exposure to high temperatures (e.g., 1176-371°C ( 350 degrees Fahrenheit to 700 degrees Fahrenheit)) in the presence of air can reduce the mechanical properties of PMC and HTPMC, and can cause thermo-oxidative degradation of the PMC and HTPMC, limiting their use to shorter times and/or lower temperature environments. For example, HTPMC typically has a limited lifetime of approximately between 1000 hours and 3000 hours at such high temperatures in the presence of air, primarily due to oxidation reactions, which reactions severely degrade the HTPMC. Preventing oxygen and/or moisture from being able to penetrate the surface of HTPMC at high temperatures would significantly reduce or delay the onset of thermo-oxidative degradation.

There have been several attempts to extend the lifetime of PMC and HTPMC substrates with various coating materials. Ceramic-based barrier coatings or layers, metal-based barrier coatings or layers, and oxygen-barrier coatings or layers, which prevent, reduce, delay or inhibit the permeation of a selected substrate with a gas, vapor, chemical and/or aroma, have been developed for use with PMC and HTPMC substrates.

However, the known coatings suffer from insufficiently low barrier properties that allow oxygen and moisture to too easily penetrate and react with the HTPMC substrate, and are also deficient in other respects. Ceramic-based barrier coatings do not prevent thermo-oxidative degradation, do not prevent oxygen diffusion, and, if exposure times are sufficiently long, do not adequately reduce temperature. Ceramic-based barrier coatings also have not demonstrated desired ranges of durability in high-flow airstreams, such as encountered in exhaust-washed aircraft structures. Also, if an HTPMC substrate is exposed to localized heating, the ability to spread the heat to reduce local substrate temperatures is desired, but ceramic-based barrier coatings only provide insulation, and cannot provide thermal spreading. Oxygen-barrier coatings cannot withstand use at high temperatures in the 176°C to 371°C (350°F to 700°F) range for extended periods without cracking, spalling, debonding and/or eroding.

In addition, ceramic-based and metal-based barrier coatings have coefficients of thermal expansion (CTEs) that are sufficiently different from (or incompatible with) CTEs of PMC and HTPMC, which can cause strain mismatch between the ceramic-based or metal-based barrier coating and the PMC or HTPMC substrate that can cause the coating to crack, spall and peel off of the substrate, thereby exposing the substrate to the environment, resulting in degradation of the PMC or HTPMC. Metallic-based and ceramic-based barrier coatings also have high densities and may add unacceptable amounts of weight.

Inorganic and organic polymer coatings have also been used as barrier coatings, but have unacceptably high permeability that allows oxygen to reach the HTMPC substrate and cause thermo-oxidative degradation. Multilayer coatings including carbon coatings over polymer substrates are not suitable for coating HTPMC.

Accordingly, there is room for improving barrier coatings for HTPMC substrates and methods for improving protection of HTPMC substrates from thermo-oxidative degradation that provide advantages over known barrier coatings and methods.

### SUMMARY

The foregoing purposes, as well as others, are achieved by applying a thin, conductive, carbon-based barrier coating with low permeability to a surface of an HTPMC substrate to protect the HTPMC substrate from exposure to high temperatures in the presence of air and prevent thermo-oxidative degradation, thereby extending the lifetime of the HTPMC substrate from between 1,000 hours to 3,000 hours to between about 10,000 hours and about 15,000 hours, or even as high as 60,000 hours.

HTPMC substrates coated with the conductive, carbon-based barrier coatings disclosed herein may be used in a wide variety of long-duration, high-temperature, and high-flow-rate environments, such as in aircraft, spacecraft, watercraft, and other craft, engine nacelles, inlet ducts, blown-flaps, exhaust-washed structures, areas near heat-generating equipment such as Auxiliary Power Units (APUs), warm-structure components for high-performance supersonic, hypersonic, and space re-entry vehicle structures, and also with propulsion systems such as power-generation turbines, automobile and other vehicle engines, engine nacelles and inlet ducts, alternative-energy applications, and related technologies. The disclosed carbon-based barrier coatings for HTPMC substrates may also be incorporated as an atomic-oxygen barrier for space applications.

Thin carbon-based barrier coatings provides barrier protection at very light weights with good flexibility, resulting in longer range, lower fuel costs, higher cargo capacity and/or improved operational performance depending on the environment in which an HTPMC with a carbon-based barrier coating is used. Using carbon-based materials in a barrier coating provides improved thermal-expansion compatibility with carbon-fiber reinforced composites, such as HTPMC, to prevent the coating from cracking, separating, spalling, peeling or debonding from the HTPMC substrate at high temperatures.

In one embodiment, a method for protecting an HTPMC structure from exposure to high temperatures in the presence of air comprises applying a conductive, carbon-based barrier coating to a surface of the HTPMC substrate as claimed in claim 1.

Application of the carbon-based barrier coating may be performed after manufacture of the HTPMC substrate and prior to use in the desired environment, or the carbon-based barrier coating may be applied after assembly of a structure made from HTPMC substrate or to repair, maintain or recondition an HTPMC substrate. The carbon-based barrier coating comprises graphene, or a mixture comprising a combination of graphene and amorphous carbon, and may be applied to the HTPMC structure by the method defined in claim 1. The carbon-based barrier coating may be applied on the surface of the HTPMC structure in one or more thin layers having a total thickness of about 10 to about 100,000 nanometers (or 0.01 to 100 micrometers and a weight of about 0.1 to about 20 grams per square meter. The carbon-based barrier coating has permeability in the range of about 0 to about 100 gas-permeance units and a first coefficient of thermal expansion that is less than 10 times a second coefficient of thermal expansion of the HTPMC structure to prevent the carbon-based barrier coating from cracking, spalling or peeling off the HTPMC structure.

In other embodiments, the carbon-based barrier coating may further comprise an erosion-barrier component, or an additional erosion-barrier layer may be applied on top of the carbon-based barrier coating to protect it from abrasion, impingement or other physical encounters that may damage the carbon-based barrier coating.

HTPMC substrates having a carbon-based barrier coating and aircraft comprising HTPMC substrates having a carbon-based barrier coating are also considered to be within the scope of the present disclosure. Other objects, features, and advantages of the various embodiments in the present disclosure will be explained in the following detailed description with reference to the appended drawings.

Further, the disclosure comprises embodiments according to the following clauses:
Clause 1. A method for protecting a high-temperature polymer-matrix composite (HTPMC) substrate from exposure to high temperatures in the presence of air, comprising:
   applying a carbon-based barrier coating to a surface of the HTPMC substrate.
Clause 2. The method of clause 1, wherein the carbon-based barrier coating comprises a carbon material selected from the group consisting of graphene, amorphous carbon, and a mixture comprising a combination of graphene and amorphous carbon.
Clause 3. The method of clause 2, wherein the carbon-based barrier coating is applied to the HTPMC structure by an application method selected from the group consisting of spraying, spin-coating, slurry deposition, extrusion, co-curing, secondary bonding, vapor deposition, sputter deposition and plasma-spraying.
Clause 4. The method of any preceding clause, wherein the carbon-based barrier coating is applied to have a thickness of 10 to 100,000 nanometers (or 0.01 to 100 microns) on the surface of the HTPMC substrate.
Clause 5. The method of any preceding clause, wherein the carbon-based barrier coating is applied to have a weight of 0.1 to 20 grams per square meter.
Clause 6. The method of any preceding clause, wherein the carbon-based barrier coating has a permeability of 0 to 100 gas-permeance units.
Clause 7. The method of any preceding clause, wherein the carbon-based barrier coating has a coefficient of thermal expansion less than 10 times a coefficient of thermal expansion of the HTPMC substrate.
Clause 8. The method of any preceding clause, wherein the carbon-based barrier coating is applied in a single layer.
Clause 9. The method of any preceding clause, further comprising:
   applying an erosion-barrier coating on top of the carbon-based barrier coating to protect the carbon-based barrier coating from abrasion and/or impingement that may damage the carbon-based barrier coating.
Clause 10. The method of clause 9, wherein applying an erosion-barrier coating comprises applying a series of thin layers having different coefficients of thermal expansion and/or different modulus to form a functionally graded coating having erosion barrier properties.
Clause 11. The method of any preceding clause, wherein the carbon-based barrier coating comprises an erosion-barrier component.
Clause 12. The method of any preceding clause, wherein the carbon-based barrier coating comprises a graphene film co-cured or secondarily bonded to the HTPMC.
Clause 13. A high-temperature polymeric-matrix composite (HTPMC) substrate comprising a carbon-based barrier coating on a surface of the HTPMC substrate to protect the HTPMC from exposure to high temperatures in the presence of air.
Clause 14. The HTPMC substrate of clause 13, wherein the carbon-based barrier coating comprises a carbon material selected from the group consisting of graphene, amorphous carbon, and a mixture comprising a combination of graphene and amorphous carbon.
Clause 15. The HTPMC substrate of any one of clauses 13-14, wherein the carbon-based barrier coating has a thickness of 10 to 100,000 nanometers (or 0.01 to 100 microns) on the surface of the HTPMC structure.
Clause 16. The HTPMC substrate of any one of clauses 13-15, wherein the carbon-based barrier coating has a weight of 0.1 to 20 grams per square meter.
Clause 17. The HTPMC substrate of any one of clauses 13-16, wherein the carbon-based barrier coating has a permeability of 0 to 100 gas-permeance units.
Clause 18. The HTPMC substrate of any one of clauses 13-17, wherein the carbon-based barrier coating has a coefficient of thermal expansion less than 10 times a coefficient of thermal expansion of the HTPMC structure.
Clause 19. The HTPMC substrate of any one of clauses 13-18, wherein the carbon-based barrier coating comprises an erosion-barrier component.
Clause 20. The HTPMC substrate of any one of clauses 13-19, further comprising an erosion-barrier coating on top of the carbon-based barrier coating.
Clause 21. The HTMPC substrate of clause 20, wherein the erosion-barrier coating comprises a series of thin layers each having a different coefficient of thermal expansion and/or a different modulus to form a functionally graded coating having erosion barrier properties.
Clause 22. An aircraft comprising the HTPMC substrate of any one of clauses 13-21.

### BRIEF DESCRIPTION OF DRAWINGS

**FIG. 1** is an illustration of an exemplary HTPMC substrate with a carbon-based barrier coating.
**FIG. 2** is an illustration of another exemplary HTPMC substrate with a carbon-based-barrier coating.
**FIG. 3** is an illustration of yet another exemplary HTPMC substrate with a carbon-based-barrier coating.
**FIG. 4** is an illustration of a flow diagram of an exemplary method for protecting HTPMC substrates from exposure to high temperatures in the presence of air.
**FIG. 5** is an illustration of a flow diagram of another exemplary method for protecting HTPMC substrates from exposure to high temperatures in the presence of air.
**FIG. 6** is an illustration of an aircraft in which HTPMC substrates with carbon-based barrier coatings may be used.

### DETAILED DESCRIPTION

In the following detailed description, various embodiments of an HTPMC substrate coated with a conductive, carbon-based barrier coating and related methods of protecting HTPMC substrates from exposure to high temperatures in the presence of air are described with reference to aerospace structures to illustrate the general principles in the present disclosure. It will be recognized by one skilled in the art that the present disclosure may be practiced in other analogous applications or environments and/or with other analogous or equivalent variations of the illustrative embodiments. For example, the conductive, carbon-based barrier coating and method for protecting HTPMC substrate from exposure to high temperatures in the presence of air could be used in the automotive industry in engine applications, or in the oil-drilling industry in oil-well applications that experience high temperatures. One of ordinary skill in the art will recognize and appreciate that the HTPMC substrate coated with a conductive, carbon-based barrier coating and related methods of protecting HTPMC substrates of the disclosure can be used in any number of applications involving such vehicles and structures. It should also be noted that those methods, procedures, components, or functions which are commonly known to persons of ordinary skill in the field of the disclosure are not described in detail herein.

The disclosure provides for an HTPMC substrate coated with a conductive, carbon-based barrier coating (or "coated HTPMC substrate") and related methods of protecting HTPMC substrates from thermo-oxidative degradation. For purposes of this application, "protect" means that oxygen and moisture cannot penetrate the carbon-based barrier coating.

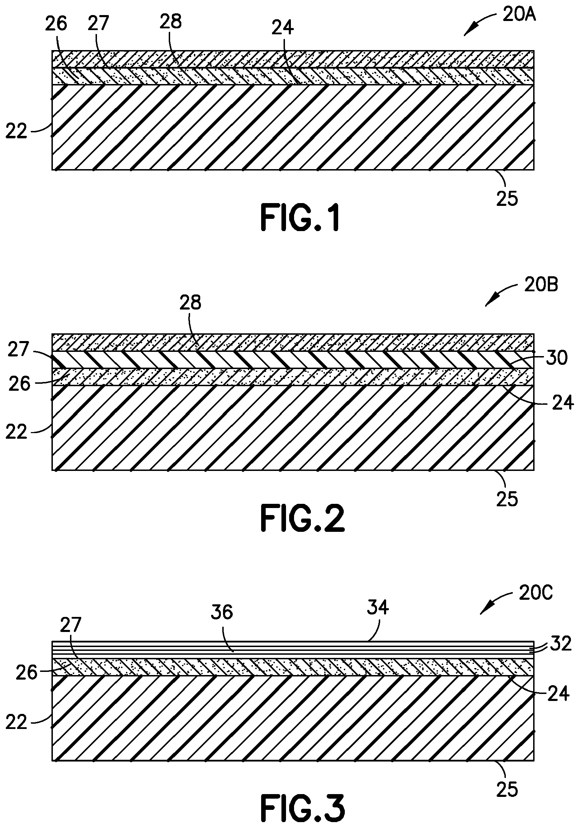

Referring more particularly to the drawings, FIG. 1 is an illustration of one of the embodiments of a coated HTPMC substrate **20A** of the disclosure. The coated HTPMC substrate **20A** comprises an HTPMC substrate **22** having a first surface **24** and a second surface **25,** and a first coefficient of thermal expansion (CTE). For purposes of this application, the coefficient of thermal expansion is defined as the change in dimension per unit change in temperature for a given material. Different materials have different rates of expansion. The lower the coefficient of thermal expansion, the less change in size the material goes through when it is subjected to temperature changes. The coefficient of thermal expansion is typically measured in the unit k⁻¹ expansion in parts per million (ppm) per degrees Celsius (°C) in temperature. The HTPMC substrate **22** may comprise a polyimide HTPMC, a bismaleimide HPTMC, inorganic polymers, and other high-temperature polymers such as polybenzoxazoles, polybenzoxazines, polyetheretherketones, or other suitable polymer-matrix composites. The CTEs of typical polyimides may be in the range of from about 20 ppm/°C to about 70 ppm/°C. The CTEs of typical inorganic polymers may be in the range of from about 5 ppm/°C to about 300 ppm/°C. The CTEs of typical organic polymers may be in the range of from about 15 ppm/°C to about 100 ppm/°C.

The coated HTPMC substrate **20A** further comprises a conductive, carbon-based barrier coating **26** applied to the first surface **24** of the HTPMC substrate **22** in one or more layers having a total thickness of about 10 to about 100,000 nanometers (or 0.01 to 100 micrometers) and a weight of about 0.1 to about 20 grams per square meter. Optionally, an erosion-barrier **28** may be applied to the outer surface **27** of the carbon-based barrier coating **26** to protect the carbon-based barrier coating **26** from abrasion, impingement or other environmental effects that may physically damage the carbon-based barrier coating **26.** Alternatively, the carbon-based barrier coating **26** may comprise an erosion-barrier component mixed into the carbon-based barrier coating **26.** For applications that require an erosion barrier **28,** the outermost layer of the coated HTPMC substrate **20A** should have erosion barrier properties.

The carbon-based barrier coating **26** of the invention comprises a carbon material selected from the group consisting of graphene, and a mixture comprising a combination of graphene and amorphous carbon. Graphene is a hexagonal array of carbon atoms extending over two dimensions (i.e., it is a one-atom-thick sheet material). Each carbon atom in graphene is covalently bonded to three other carbon atoms, providing a graphene sheet with extraordinary strength and heat conductance. Sheets of graphene may be layered and held together with space between each sheet by electrostatic forces call van der Waals bonding. Amorphous carbon is carbon that does not have any clear shape, form or crystalline structure. It is formed when a material containing carbon is burned without enough oxygen for it to burn completely. This black soot, also know as lampblack, gas black, channel black or carbon black, is used to make inks, paints and rubber products, and can be pressed into shapes to form a wide variety of products, such as the cores of most dry-cell batteries.

The carbon-based barrier coating **26** is applied to the HTPMC substrate **22** be the method claimed in claim 1.

Prior to application of the carbon-based barrier coating **26,** the first surface **24** of the HTPMC substrate **22** is treated with one of the following exemplary treatments or another suitable treatment to optimize bonding reactivity with the carbon-based barrier coating **26:** chemical etching to make the HTPMC substrate **22** and the carbon-based barrier coating **26** chemically compatible, making the first surface **24** acidic or basic to enhance the reactivity, making the first surface **24** polar so it is charged to improve reactivity, functionalizing the first surface **24** by placing reactive functional groups on the surface, physically abrading the first surface **24,** oxidizing the first surface **24,** or a combination of such treatments to maximize the durability and effectiveness of the bond between the HTPMC substrate **22** and the carbon-based barrier coating **26.**

Alternatively, an intermediate metalized layer may be applied, such as a flame-sprayed metal or the like, as described in commonly-owned U.S. Patent No. 8,778,498. The intermediate layer is preferably a low-modulus material that can strain without creating stress. Additionally, very thin coatings can be made such that they can easily deform without breaking or debonding. Making very thin layers of traditionally brittle materials (e.g. ceramics) can yield very flexible, tough materials because the reduction in thickness leads to a reduction in the presence of flaws, which control material strength and, hence, brittleness.

No according to the invention, various forms of graphene that are commercially available may be used to form the carbon-based barrier coating **26.** For example, chemical vapor deposition (CVD) may be used to create a graphene film that may be co-cured or secondarily bonded to the HTPMC substrate **22.** CVD is a chemical process used to produce high-purity, high-performance solid materials. The process is often used in the semiconductor industry to produce thin films. In typical CVD, the wafer (substrate) is exposed to one or more volatile precursors, which react and/or decompose on the substrate surface to produce the desired deposit. Frequently, volatile by-products are also produced, which are removed by gas flow through the reaction chamber. Microfabrication processes widely use CVD to deposit materials in various forms, including: monocrystalline, polycrystalline, amorphous, and epitaxial. These materials include: silicon, carbon fiber, carbon nanofibers, fluorocarbons, filaments, carbon nanotubes, SiO₂, silicon-germanium, tungsten, silicon carbide, silicon nitride, silicon oxynitride, titanium nitride, and various high-k dielectrics.

According to the invention, the HTPMC substrate **22** may have a metalized coating that has a solution of graphene oxide deposited on it with the metal subsequently acting as a chemical reducer to convert the graphene oxide into chemically converted graphene.

In another embodiment, diamond-like carbon may be deposited directly onto a treated first surface **24** of an HTPMC substrate **22** by plasma deposition, ion-beam sputtering or laser vaporization, followed by treatment with a low-energy ion beam to convert to graphene as disclosed, for example, in Tinchev, S.S., "Crystallization of Diamond-Like Carbon to Graphene Under Low-Energy Ion Beam Modification," Institute of Electronics, Bulgarian Academy of Sciences. Tinchev used argon ions to irradiate the upper 1 nanometer of a diamond-like film. Plasma-source ion implantation or r.f. plasma-enhanced chemical vapor deposition may be used to deposit diamond-like carbon directly onto polymeric substrates. Examples of these methods are disclosed, for example, in Stoica, A et al., "Plasma Enhanced Chemical Vapor Deposition of Diamond-like Carbon Coatings on Polymer Substrates," WDS'09 Proceedings of Contributed Papers, Part III, 169-174, 2009 and N.K. Cuong, "Diamond-like carbon films deposited on polymers by plasma-enhanced chemical vapor deposition," Surface and Coatings Technology 174 -175 (2003) 1024-1028. Other technologies for treating an HTPMC surface may also be used, such as the manufacturing technology offered by Modumetal, Seattle, Washington, for growing nanonlaminate structures. *See* www.modumetal.com/technology.

Amorphous carbon is applied directly onto an "activated" substrate by low-pressure plasma deposition. Low-pressure deposition methods for applying amorphous carbon or diamond-like to HTPMC substrates in general are known, and may be used to deposit a carbon layer onto an HTPMC substrate **22.** Subsequently, the carbon layer is converted *in situ* to contain sufficient graphene content to act as an oxygen barrier sufficient to form the carbon-based barrier coating **26.** Depending on the level of conversion, the ratio of graphene to amorphous carbon may be adjusted or tailored. *See, for example,* the above referenced Tinchev article.

Once applied, the carbon-based barrier coating **26** has a permeability of about 0 to about 100 gas-permeance units to provide an effective barrier to oxygen and moisture. The carbon-based barrier coating **26** also has a second coefficient of thermal expansion (CTE) sufficiently close to the first CTE of the HTPMC substrate **22** to permit co-curing without spalling, cracking or peeling. In preferred embodiments, the second CTE of the carbon-based barrier coating **26** is less than 10 times the first CTE of the HTPMC substrate **22.** The carbon-based barrier coating **26** also has good flexibility, based on modulus and elongation, preferably in the range of about 5 to about 500 GPa. More preferably, the modulus ranges between about 5 to about 100 GPa. Elongation is preferably between 1% and 10%, and more preferably between 1% and 5%. Due to the conductive carbon material in the carbon-based barrier coating **26,** the carbon-based barrier coating **26** has the ability to spread heat and reduce the temperature of the HTPMC substrate **22.**

An erosion barrier **28** may be applied over the carbon-based barrier coating **26** when it is desired to protect the carbon-based barrier coating from abrasion or impingement from physical objects, typically in applications that involve high airflow. Applications that do not involve high airflow, but do involve high temperatures, such as APUs, do not require an erosion barrier **28.** The erosion barrier **28** may be applied with any type of suitable application method described above. Examples of suitable erosion barriers **28** include thin ceramics or metallic-based coatings applied to the outer surface **27** of the carbon-based barrier coating **26,** such as (1) SixCy/DLC multilayers deposited by chemical vapor deposition (CVD); (2) WC/TaC/TiC processed by electrospark deposition; and (3) polymer ceramic mixtures applied by means of an aqueous synthesis. In applications that require an erosion barrier **28,** the outermost layer of the coated HTPMC substrates **20A, 20B** and **20C** should have erosion barrier properties.

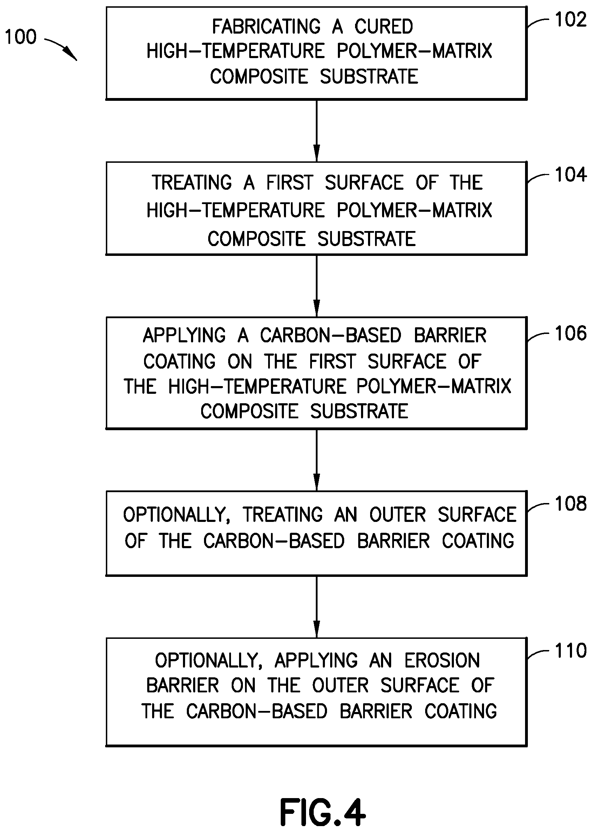

FIG. 4 is an illustration of a flow diagram of one of the embodiments of a method **100** of protecting an HTPMC substrate **22** from exposure to high temperatures in the presence of air and preventing thermo-oxidative degradation of the HTPMC substrate **22.** In this embodiment, the HTPMC substrate is fabricated and cured prior to application of the carbon-based barrier coating **26.** The method **100** comprises step **102** of fabricating a cured HTPMC substrate **22** having a first CTE and a first surface **24** and second surface **25.** In step **104,** the first surface **24** of the HTPMC substrate **22** is treated with one of the following exemplary treatments or another suitable treatment to optimize bonding reactivity with the carbon-based barrier coating **26:** chemical etching to make the HTPMC substrate **22** and the carbon-based barrier coating **26** chemically compatible, making the first surface **24** acidic or basic to enhance the reactivity, making the first surface **24** polar so it is charged to improve reactivity, functionalizing the first surface **24** by placing reactive functional groups on the surface, physically abrading the first surface **24,** oxidizing the first surface **24,** or a combination of such treatments to maximize the durability and effectiveness of the bond between the HTPMC substrate **22** and the carbon-based barrier coating **26.** Alternatively, an intermediate layer may be applied, such as a flexible, low-modulus material capable of accommodating strain differences between the coating and the HTPMC or the like. In step **106,** a conductive, carbon-based barrier coating **26** is applied on the first surface **24** of the HTPMC substrate **22** in accordance with the application methods described herein.

The method **100** further comprises the optional steps **108** and **110** of treating an outer surface **27** of the carbon-based barrier coating **26** as described herein (step **108**) and applying an erosion barrier **28** on the outer surface **27** of the carbon-based barrier coating **26** (step **110**).

Referring to FIG. 2, in an alternative embodiment of a coated HTPMC substrate **20B,** the outer surface **27** of the carbon-based barrier coating **26** may be chemically activated by etching, plasma treatment, or the like. Subsequently, a high-elongation or low-modulus intermediate layer **30** may be applied as described above before the application of a durable, erosion barrier **28.** Alternately, referring to the coated HTPMC substrate **20C** shown in FIG. 3, a series of very thin layers **32** may be applied above the carbon-based barrier coating **26** with each of the very thin layers **32** having a slightly different coefficient of thermal expansion and/or modulus to form a functionally graded coating **36** having the most-durable material on the outer surface **34** of the functionally graded coating **36.** The functionally graded coating **36** should provide sufficient erosion resistance that a separate erosion barrier **28** is not necessary in this embodiment. That is, the functionally graded coating **36** acts as the erosion barrier coating **28.** In this alternative embodiment, chemical activation of the outer surface **27** of the carbon-based barrier coating **26** and each of the very thin layers **32** is done as necessary to ensure adhesion between adjacent layers. The functionally graded coating **36** is deposited using layer-by-layer (LBL) deposition with each of the very thin layers **32** possessing a different electrical charge (polarity) than the layer above or below it. One reference showing a hybrid material that could be part of a functionally graded coating is found at A. N. Banerjee, "Ambient-temperature fabrication of microporous carbon terminated with graphene walls by sputtering process for hydrogen storage applications," Thin Solid Films 537 (2013) 49-57, which describes a metal/graphene hybrid formed *in situ.*

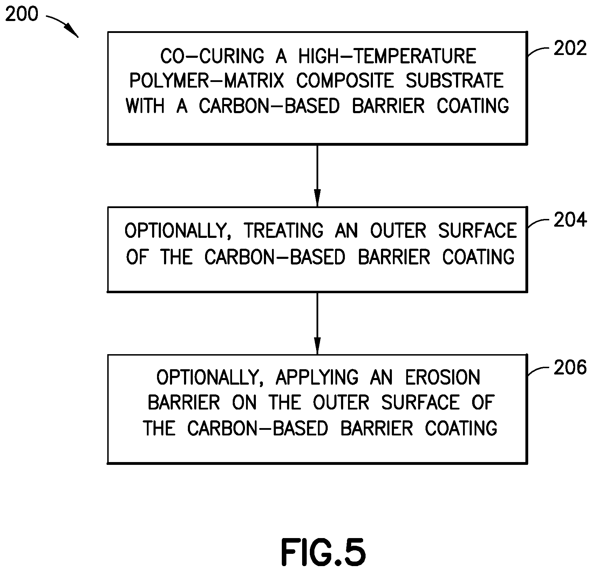

FIG. 5 is an illustration of a flow diagram of another method **200** of protecting an HTPMC substrate **22** from exposure to high temperatures in the presence of air and preventing thermo-oxidative degradation of the HTPMC substrate **22.** In this embodiment, the HTPMC substrate is fabricated and co-cured with a carbon-based barrier coating **26.** The method **200** comprises step **202** of fabricating and co-curing an HTPMC substrate **22** having a first CTE and a first surface **24** and second surface **25** with a conductive, carbon-based barrier coating **26.**

The method **200** further comprises the optional steps **204** and **206** of treating an outer surface **27** of the carbon-based barrier coating **26** (step **204**) and applying an erosion barrier **28** on the outer surface **27** of the carbon-based barrier coating **26** (step **206**) as described above with regard to steps **108** and **110** in method **100** and FIGS. 2 and 3.

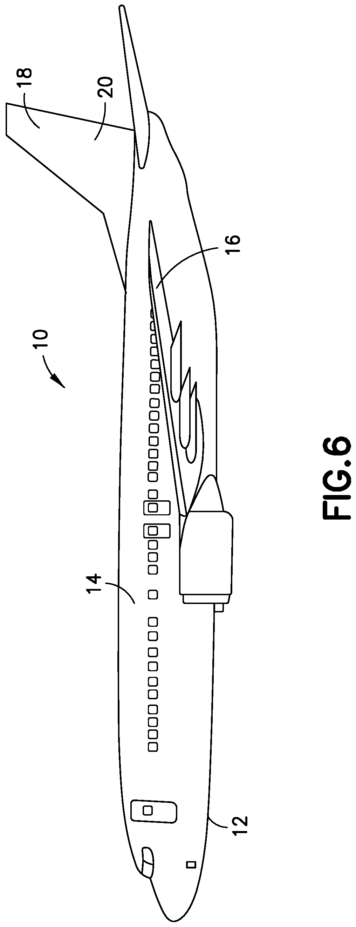

In an exemplary field of use, FIG. 6 shows an aircraft **10** in which advantageous embodiments of the coated HTPMC substrates **20A, 20B** and **20C** and method of the disclosure may be implemented (*see* FIGS. 1-3). FIG. 6 shows the aircraft **10** comprising an aircraft structure **12** including an elongated body **14,** at least one wing **16** extending laterally from the body **14,** and at least one tail **18** extending longitudinally from the body **14.** In addition to fabricating coated HTPMC substrate **20A, 20B** and **20C** as described herein, the methods may also be used for repair or maintenance of HTPMC substrates **22** used in aircraft **10.** For example, carbon-based barrier coating **26** may be applied to HTPMC substrates **22** already in service to extend the life of the substrates.

## Claims

1. A method for protecting a high-temperature polymer-matrix composite (HTPMC) substrate from exposure to high temperatures in the presence of air, comprising:
applying a carbon-based barrier coating to a surface of the HTPMC substrate, the carbon-based barrier coating consisting of graphene or a mixture consisting of a combination of graphene and amorphous carbon, wherein the carbon barrier coating is formed by:
(A) providing a metalised coating on the surface of the HTPMC substrate, and depositing a solution of graphene oxide thereon, whereby the metal acts as a chemical reducer to convert the graphene oxide into chemically converted graphene; or
(B)
(i) treating the surface of the HTPMC substrate to optimise bonding reactivity with the carbon-based barrier coating; and
(ii) depositing diamond-like carbon directly onto the treated surface by plasma deposition, ion-beam sputtering or laser vaporisation, followed by treatment with a low-energy ion beam to convert to graphene, or
depositing a carbon layer of amorphous carbon directly onto the treated surface by low-pressure plasma deposition and converting the carbon layer in situ to form graphene.

2. The method of claim 1, wherein the step B(i) of activating the surface of the HTPMC substrate is by one or more of the following techniques:
chemical etching the surface;
making the surface acidic or basic;
making the surface polar;
functionalising the surface by placing reactive functional groups on the surface;
physically abrading the surface; and
oxidising the surface.

3. The method of claim 1, wherein the carbon-based barrier coating is applied in a single layer.

4. The method of any preceding claim, further comprising:
applying an erosion-barrier coating on top of the carbon-based barrier coating to protect the carbon-based barrier coating from abrasion and/or impingement that may damage the carbon-based barrier coating.

5. The method of claim 4, wherein applying an erosion-barrier coating comprises applying a series of thin layers having different coefficients of thermal expansion and/or different modulus to form a functionally graded coating having erosion barrier properties.

6. A high-temperature polymeric-matrix composite (HTPMC) substrate obtainable by the method of any of the preceding claims.

## Patentansprüche

1. Verfahren zum Schutz eines Hochtemperatur-Polymer-Matrix-Verbundsubstrats (HTPMC) vor der Einwirkung hoher Temperaturen in Gegenwart von Luft, umfassend:
Aufbringen einer kohlenstoffbasierten Sperrschicht auf eine Oberfläche des HTPMC-Substrats, wobei die kohlenstoffbasierte Sperrschicht aus Graphen oder einer Mischung, bestehend aus einer Kombination aus Graphen und amorphem Kohlenstoff, besteht, wobei die Kohlenstoffsperrschicht gebildet wird durch:
(A) Bereitstellen einer metallisierten Beschichtung auf der Oberfläche des HTPMC-Substrats und Abscheiden einer Lösung von Graphenoxid darauf, wobei das Metall als chemisches Reduktionsmittel wirkt, um das Graphenoxid in chemisch umgewandeltes Graphen umzuwandeln; oder
(B)
(i) Behandeln der Oberfläche des HTPMC-Substrats, um die Bindungsreaktivität mit der kohlenstoffbasierten Sperrschicht zu optimieren; und
(ii) Abscheiden von diamantartigem Kohlenstoff direkt auf der behandelten Oberfläche durch Plasmaabscheidung, Ionenstrahl-Sputtern oder Laserverdampfen, gefolgt von einer Behandlung mit einem niederenergetischen Ionenstrahl zur Umwandlung in Graphen, oder
Abscheiden einer Kohlenstoffschicht aus amorphem Kohlenstoff direkt auf der behandelten Oberfläche durch Niederdruck-Plasmaabscheidung und Umwandlung der Kohlenstoffschicht in situ in Graphen.

2. Verfahren nach Anspruch 1, bei dem der Schritt B(i) zum Aktivieren der Oberfläche des HTPMC-Substrats durch eine oder mehrere der folgenden Techniken erfolgt:
chemisches Ätzen der Oberfläche;
sauer oder basisch Machen der Oberfläche;
Polarisieren der Oberfläche;
Funktionalisieren der Oberfläche durch Platzieren von reaktiven Funktionsgruppen auf der Oberfläche;
physisches Abtragen der Oberfläche; und
Oxidieren der Oberfläche.

3. Verfahren nach Anspruch 1, bei dem die kohlenstoffbasierte Sperrschicht in einer einzigen Schicht aufgebracht wird.

4. Verfahren nach einem vorhergehenden Anspruch, ferner umfassend:
Aufbringen einer Erosionssperrschicht auf die kohlenstoffbasierte Sperrschicht, um die kohlenstoffbasierte Sperrschicht vor Abrieb und/oder Aufprall zu schützen, der die kohlenstoffbasierte Sperrschicht beschädigen kann.

5. Verfahren nach Anspruch 4, bei dem das Aufbringen einer Erosionssperrschicht das Aufbringen einer Folge von dünnen Schichten mit unterschiedlichen Wärmeausdehnungskoeffizienten und/oder unterschiedlichen Modulen zum Bilden einer funktionell abgestuften Beschichtung mit Erosionssperreigenschaften umfasst.

6. Hochtemperatur-Polymer-Matrix-Verbundsubstrat (HTPMC), erhältlich durch das Verfahren nach einem der vorhergehenden Ansprüche.

## Revendications

1. Procédé de protection d'un substrat en composite à matrice polymère haute température (HTPMC) à l'encontre d'une exposition à des températures élevées en présence d'air, comprenant les étapes consistant à :
appliquer un revêtement de protection à base de carbone sur une surface du substrat HTPMC, le revêtement de protection à base de carbone consistant en du graphène ou en un mélange constitué d'une combinaison de graphène et de carbone amorphe, dans lequel le revêtement de protection à base de carbone est formé par les étapes consistant à :
(A) fournir un revêtement métallisé sur la surface du substrat HTPMC et y déposer une solution d'oxyde de graphène, de sorte que le métal agit comme un réducteur chimique pour convertir l'oxyde de graphène en graphène converti chimiquement ; ou
(B)
(i) traiter la surface du substrat HTPMC pour optimiser la réactivité de liaison avec le revêtement de protection à base de carbone ; et
(ii) déposer du carbone analogue à du diamant directement sur la surface traitée par dépôt au plasma, pulvérisation par faisceau ionique ou vaporisation au laser, opération suivie d'un traitement avec un faisceau ionique à basse énergie pour conversion en graphène, ou
déposer une couche de carbone constituée de carbone amorphe directement sur la surface traitée par dépôt au plasma basse pression et convertir la couche de carbone in situ pour former du graphène.

2. Procédé selon la revendication 1, dans lequel l'étape B(i) d'activation de la surface du substrat HTPMC fait appel à une ou plusieurs des techniques suivantes :
graver la surface chimiquement ;
rendre la surface acide ou basique ;
rendre la surface polaire ;
fonctionnaliser la surface en plaçant des groupes fonctionnels réactifs sur la surface ;
abraser physiquement la surface ; et
oxyder la surface.

3. Procédé selon la revendication 1, dans lequel le revêtement de protection à base de carbone est appliqué en une couche unique.

4. Procédé selon l'une quelconque des revendications précédentes, comprenant en outre :
l'application d'un revêtement de protection contre l'érosion sur le revêtement de protection à base de carbone pour protéger le revêtement de protection à base de carbone de l'abrasion et/ou d'un impact pouvant déteriorer le revêtement de protection à base de carbone.

5. Procédé selon la revendication 4, dans lequel l'application d'un revêtement de protection contre l'érosion comprend l'application d'une série de couches minces ayant différents coefficients de dilatation thermique et/ou différents modules pour former un revêtement à gradient de fonctionnalité possédant des propriétés de protection contre l'érosion.

6. Substrat en composite à matrice polymère haute température (HTPMC) pouvant être obtenu par le procédé selon l'une quelconque des revendications précédentes.
